# EUROPEAN PATENT APPLICATION

(11) **EP 4 401 514 A1**
(43) Date of publication of application: **17.07.2024**
(21) Application number: 22958754.8
(22) Date of filing: 14.09.2022
(51) Int. Cl.: H05H 1/24

(54) **ACTIVE GAS GENERATION DEVICE**

(71) Applicant: TOSHIBA MITSUBISHI-ELECTRIC INDUSTRIAL SYSTEMS CORPORATION, Chuo-ku Tokyo 104-0031 (JP)
(72) Inventor: WATANABE, Kensuke, Tokyo 104-0031 (JP); ARITA, Ren, Tokyo 104-0031 (JP)
(74) Representative: TBK
(86) International application number: PCT/JP2022/034306
(87) International publication number: WO 2024/057424

(57) **Abstract**

An object of the present disclosure is to provide an active gas generation apparatus capable of supplying a high concentration active gas. In an active gas generation apparatus (5) according to the present disclosure, a first number of high voltage electrode structures (13) are held in a holding space (S54) in corresponding grooves (54) in the first number of grooves (54), respectively, and the second number of ground electrode structures (14, 3, 4) are held in the holding space (S54) in corresponding grooves (54) in the second number of grooves (54), respectively. The first number of high voltage electrode structures (13) and the second number of ground electrode structures (14, 3, 4) are alternately disposed along a Y direction, and a first planar region of each of the first number of high voltage electrode structures (13) and a second planar region of each of the second number of ground electrode structures (14, 3, 4) face each other with a separation space (S56) therebetween.

## Description

### TECHNICAL FIELD

The present disclosure relates to an active gas generation apparatus generating active gas in a discharge space.

### BACKGROUND ART

An active gas generation apparatus using a dielectric barrier discharge system of a parallel plate system used in a semiconductor deposition process is an example of a conventional representative active gas generation apparatus. For example, an active gas generation apparatus disclosed in Patent Document 1 is an example of a conventional active gas generation apparatus using a dielectric barrier discharge system.

In the conventional active gas generation apparatus disclosed in Patent Document 1, a plurality of gas supply holes provided to a high voltage-side electrode constituting part and a plurality of gas ejection holes provided to a ground-side electrode constituting part are disposed so that the plurality of gas supply holes and the plurality of gas ejection holes are not overlapped with each other in a plan view.

The active gas generation apparatus disclosed in Patent Document 1 has first and second positional relationships described hereinafter. The first positional relationship is a relationship in which a discharge space is provided in a region where the plurality of gas supply holes and the plurality of gas ejection holes are not formed. The second positional relationship is a relationship in which each of the plurality of gas ejection holes includes adjacent four gas supply holes in a plan view in the plurality of gas supply holes, and all of four distances from the adjacent four gas supply holes to the corresponding gas ejection holes are the same as each other.

### PRIOR ART DOCUMENTS

### PATENT DOCUMENT(S)

Patent Document 1: Japanese Patent No. 6719856

### SUMMARY

### PROBLEM TO BE SOLVED BY THE INVENTION

The conventional active gas generation apparatus described above is provided with the plurality of gas ejection holes in the ground-side electrode constituting part to supply active gas (gas containing radical) passing through the discharge space located around the plurality of gas ejection holes from the plurality of gas ejection holes to a wafer serving as a substrate.

That is to say, in the conventional active gas generation apparatus, after the active gas is generated in the discharge space from material gas supplied through the plurality of gas supply holes, the active gas is discharged from the plurality of gas ejection holes to the wafer on a lower side. At this time, the active gas generated in the discharge space is diffused in a horizontal direction, and then proceeds to the gas ejection holes in a narrowed path again, thus radical in the active gas is inactivated in this process. The discharge space is provided in an interelectrode space provided between the high voltage-side electrode constituting part and the ground-side electrode constituting part.

In this manner, the conventional active gas generation apparatus has a first problem that a flow path is narrowed as the active gas proceeds to the gas ejection holes, and this configuration leads to inactivation of the active gas, thus high concentration active gas cannot be supplied.

Furthermore, the active gas supplied into a film deposition processing chamber in a subsequent stage is vertically blown onto a surface of the wafer disposed immediately below the film deposition processing chamber. Thus, large radical inactivation occurs at a timing of when the active gas collides with the wafer, and a flow speed of the active gas is significantly reduced. As a result, the conventional active gas generation apparatus has a second problem that a distance of the active gas supplied on the wafer in a limited time is extremely short. The second problem is described in detail hereinafter.

The active gas supplied from the plurality of gas ejection holes toward the wafer forms a columnar like gas flux which does not spread so much and reaches the wafer, thus the active gas collides with the wafer in an extremely limited area, and spreads from a position where the active gas collides to a surrounding area. Such a flow of the active gas causes a large volume of inactivation in the active gas in a first collision with the wafer and extremely reduces the gas flow speed of the active gas. Thus, an area of the wafer which can be processed before the active gas is completely inactivated is extremely limited.

Considered is an improvement structure in which the number of gas ejection holes is increased to uniformize a thickness of a thin film formed on the wafer in consideration of this second problem. In the improvement structure, when the number of gas ejection holes is increased, the number of gas supply holes provided to correspond to the gas ejection holes also needs to be increased.

However, there is a limitation regarding the interelectrode space described above in the improvement structure that a space overlapped with at least one of the plurality of gas supply holes and the plurality of gas ejection holes in a plan view cannot be provided in the discharge space. This limitation is caused by applying the first positional relationship described above. In this manner, the improvement structure described above has a limitation that a size of the discharge space formed in the space where the gas ejection holes and the gas supply holes are not overlapped with each other in a plan view is reduced as the number of gas supply holes and gas ejection holes increases.

In this manner, when the number of gas ejection holes and gas supply holes formed in the improvement structure described above is increased, the discharge space is reduced due to the limitation described above, and this configuration leads to reduction of a radical concentration contained in the active gas. Accordingly, the improvement structure described above causes increase of a time of processing the wafer, and cannot resultingly resolve the second problem described above.

An object of the present disclosure is to provide an active gas generation apparatus capable of solving at least the first problem described above and supplying high concentration active gas.

### MEANS TO SOLVE THE PROBLEM

An active gas generation apparatus according to the present disclosure includes: a material gas supply space; an active gas output space; a first number of high voltage electrode structures each having a rectangular first planar region in a plan view; a second number of ground electrode structures each having a rectangular second planar region in a plan view; and a discharge space structure provided between the material gas supply space and the active gas output space, wherein the discharge space structure includes a plurality of grooves provided along a predetermined formation direction, the plurality of grooves are provided separately from each other, each of the plurality of grooves includes a holding space, the first number of high voltage electrode structures and a first number of grooves in the plurality of grooves correspond to each other, the first number of high voltage electrode structures are held in the holding space in corresponding grooves in the first number of grooves, respectively, the second number of ground electrode structures and a second number of grooves in the plurality of grooves correspond to each other, the second number of ground electrode structures are held in the holding space in corresponding grooves in the second number of grooves, respectively, the first number of high voltage electrode structures and the second number of ground electrode structures are alternately disposed along the predetermined formation direction, the first planar region of each of the first number of high voltage electrode structures and the second planar region of each of the second number of ground electrode structures face each other with a separation space therebetween, alternating-current voltage is applied to the first number of high voltage electrode structures, the second number of ground electrode structures are set to have reference potential, the separation space includes a discharge space, an opening part of the discharge space on a side of the material gas supply space serves as a gas supply port, an opening part of the discharge space on a side of the active gas output space serves as a gas ejection port, and a direction from the gas supply port toward the gas ejection port is regulated as a gas flow direction.

### EFFECTS OF THE INVENTION

In the active gas generation apparatus according to the present disclosure, the high voltage electrode structure and the ground electrode structure adjacent to each other in the predetermined formation direction and the discharge space between the high voltage electrode structure and the ground electrode structure adjacent to each other constitute one unit of discharge cell. Accordingly, when at least one of the first number and the second number is set to be equal to or larger than "2", the plurality of discharge cells can be provided in the discharge space structure.

The material gas supplied from the material gas supply space via the gas supply port is activated in the discharge space in each of the plurality of discharge cells to generate the active gas. The active gas is ejected from the gas ejection port toward the active gas output space.

According to the active gas generation apparatus of the present disclosure, a large part of a gas distribution path from the gas supply port to the gas ejection port can serve as the discharge space, and a structure being an obstacle needs not be provided to the gas distribution path. Thus, the active gas generation apparatus according to the present disclosure can effectively suppress inactivation of the active gas by reason that the active gas flows smoothly in the discharge space.

As a result, the active gas generation apparatus according to the present disclosure can supply the high concentration active gas from the gas ejection port of each of the plurality of discharge cells to an active gas output space in a subsequent stage.

In addition, the active gas generation apparatus according to the present disclosure can constitute the plurality of discharge cells by a comparatively simple structure of holding the first number of high voltage electrode structures in the holding space in the first number of grooves and holding the second number of ground electrode structures in the holding space in the second number of grooves, thus can achieve reduction of manufacturing cost.

These and other objects, features, aspects and advantages of the present disclosure will become more apparent from the following detailed description of the present disclosure when taken in conjunction with the accompanying drawings.

### BRIEF DESCRIPTION OF DRAWINGS

[Fig. 1] An explanation diagram illustrating a structure of an active gas generation apparatus according to the present embodiment.
[Fig. 2] An explanation diagram illustrating a detailed structure of a focus region in Fig. 1.
[Fig. 3] An explanation diagram illustrating a structure of a high voltage apply electrode part.
[Fig. 4] An explanation diagram illustrating a structure of a ground potential electrode part.
[Fig. 5] An explanation diagram (No. 1) illustrating a structure of a single electrode dielectric film.
[Fig. 6] An explanation diagram (No. 2) illustrating a structure of a single electrode dielectric film.
[Fig. 7] An explanation diagram (No. 1) illustrating a state of holding the high voltage electrode structure and the ground electrode structure in the plurality of grooves.
[Fig. 8] An explanation diagram (No. 1) illustrating a state of holding the high voltage electrode structure and the ground electrode structure in the plurality of grooves.
[Fig. 9] An explanation diagram illustrating a whole structure of a generator base flange.
[Fig. 10] An explanation diagram illustrating a structure of a focus region in Fig. 9.
[Fig. 11] A perspective view illustrating a whole structure (initial state) of the generator base flange.
[Fig. 12] A perspective view illustrating a whole structure (completion state) of the generator base flange.
[Fig. 13] An explanation diagram schematically illustrating a structure of a press member.
[Fig. 14] An explanation diagram schematically illustrating a usage example of a blank component.

### DESCRIPTION OF EMBODIMENT(S)

### <Embodiment>

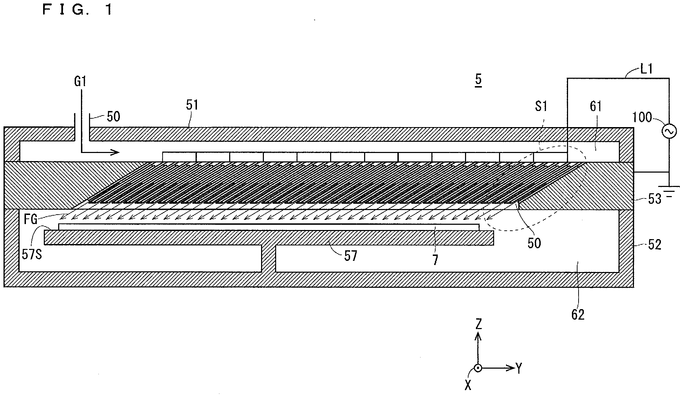

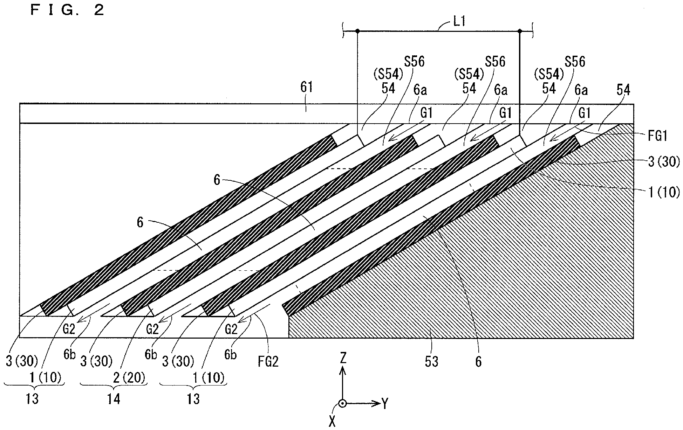

Fig. 1 is an explanation diagram illustrating a structure of an active gas generation apparatus 5 according to the present embodiment. Fig. 2 is an explanation diagram illustrating a detailed structure of a focus region S1 in Fig. 1. An XYZ rectangular coordinate system is illustrated in each of Fig. 1 and Fig. 2.

As illustrated in these diagrams, the active gas generation apparatus 5 according to the present embodiment includes a generator cover 51, a chamber 52, a generator base flange 53, a high frequency power source 100, a first number of high voltage electrode structures 13, and a second number of ground electrode structures 14 as main constituent elements.

The generator base flange 53 is provided on the chamber 52, and the generator cover 51 is provided on the generator base flange 53. The generator base flange 53 as a discharge space structure has conductivity.

A material gas supply space 61 for material gas G1 is provided on an upper side of the generator base flange 53 by the generator base flange 53 and the generator cover 51. An active gas output space 62 for material gas G2 is provided on a lower side of the generator base flange 53 by the generator base flange 53 and the chamber 52.

In this manner, in the active gas generation apparatus 5 according to the present embodiment, the generator base flange 53 as the discharge space structure is provided between the material gas supply space 61 and the active gas output space 62.

The generator base flange 53 includes a plurality of grooves 54 provided along a Y direction as a predetermined formation direction. Each of the plurality of grooves 54 is a groove for locating an electrode structure.

As illustrated in Fig. 2, the plurality of grooves 54 are provided separately from each other, and each of the plurality of grooves 54 includes a holding space S54 extending along a gas flow direction FG (FG1, FG2). The gas flow direction FG1 is a flow direction of the material gas G1 and the gas flow direction FG2 is a flow direction of the active gas G2 as illustrated in Fig. 2. The gas flow direction FG1 and the gas flow direction FG2 are the same direction. When the gas flow direction FG1 and FG2 are collectively referred, they are simply referred to as "the gas flow direction FG".

A wafer support table 57 as a substrate support table is provided in the active gas output space 62 of the chamber 52, and the wafer support table 57 includes a substrate mounting surface 57S on an upper portion. The wafer support table 57 can locate a wafer 7 as a substrate on the substrate mounting surface 57S.

As described hereinafter, the first number of high voltage electrode structures 13 and a first number of grooves in the plurality of grooves 54 correspond to each other, and the first number of high voltage electrode structures 13 are held in the holding space S54 in a corresponding groove 54 in the first number of grooves 54.

In the similar manner, the second number of ground electrode structures 14 and a second number of grooves 54 in the plurality of grooves 54 correspond to each other, and the second number of ground electrode structures 14 are held in the holding space S54 in a corresponding groove 54 in the second number of grooves 54. As described in detail hereinafter, the second number of ground electrode structures include a single electrode dielectric film 3 and a single electrode dielectric film 4 each having a structure other than the ground electrode structure 14. The ground electrode structure 14 is representatively described hereinafter, and the second number of ground electrode structures 14 are described.

As illustrated in Fig. 2, the first number of high voltage electrode structures 13 and the second number of ground electrode structures 14 are alternately disposed along the Y direction.

As illustrated in Fig. 2, alternating-current voltage is applied to the first number of high voltage electrode structures 13 from the high frequency power source 100 via an electrode connection line L1, and the second number of ground electrode structure is set to have ground potential as reference potential via the generator base flange 53. The ground potential is supplied to the generator base flange 53.

As illustrated in Fig. 2, a separation space S56 is provided between the high voltage electrode structure 13 and the ground electrode structure 14 adjacent to each other in the Y direction, and a part of the separation space S56 serves as the discharge space 6.

In the discharge space 6, an opening part on a side of the material gas supply space 61 serves as a gas supply port 6a, an opening part on a side of the active gas output space 62 serves as a gas ejection port 6b. Each of the gas supply port 6a and the gas ejection port 6b has a vertically-long slit-like shape in a plan view in an XY plane surface.

A direction from the gas supply port 6a toward the gas ejection port 6b is the gas flow direction FG. As illustrated in Fig. 1 and Fig. 2, the gas flow direction FG is set to be an oblique direction having a significant predetermined inclination not "0" with respect to a vertical direction (Z direction) based on the substrate mounting surface 57S. For example, 30° to 60° is considered as the predetermined inclination. The predetermined inclination is determined based on a gas flow rate of the injectable material gas, an occupation area of the generator base flange 53, and a size of the chamber 52, for example.

In the active gas generation apparatus 5 according to the present embodiment, an active gas generation function of generating the active gas G2 is achieved by a combination structure of the generator cover 51 and the generator base flange 53. The generator base flange 53 holds the first number of high voltage electrode structures 13 and the second number of ground electrode structures 14.

The material gas G1 is supplied from a gas supply opening part 50 on an upper portion of the generator cover 51 into the material gas supply space 61, and the material gas G1 in the material gas supply space 61 is supplied from the gas supply port 6a into the discharge space 6 along the gas flow direction FG1. A dielectric barrier discharge is generated in the discharge space 6, thus the active gas G2 (gas containing radical) is generated from the material gas G1 in the discharge space 6. The generated active gas G2 is blown onto the wafer 7 in the active gas output space 62 along the gas flow direction FG2 from the gas ejection port 6b.

The active gas G2 ejected from the gas ejection port 6b is blown in the oblique direction described above with respect to the surface of the wafer 7. In this manner, the active gas generation function can be achieved by a combination structure of the generator cover 51 and the generator base flange 53.

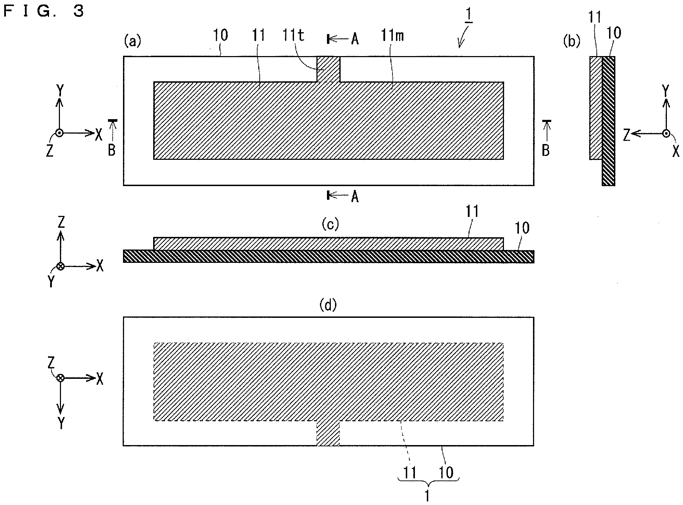

Fig. 3 is an explanation diagram illustrating a structure of the high voltage apply electrode part 1 as a constituent element of the high voltage electrode structure 13. Fig. 3(a) is a top view, Fig. 3(b) is an A-A cross-sectional view of Fig. 3(a), Fig. 3(c) is a B-B cross-sectional view of Fig. 3(a), and Fig. 3(d) is a bottom view. An XYZ rectangular coordinate system is illustrated in each of Fig. 3(a) to Fig. 3(d).

In Fig. 3 and Fig. 4 to Fig. 6 described hereinafter, a lamination direction is a Z direction, a longitudinal direction of a rectangular planar region described hereinafter is an X direction, and a short-side direction thereof is a Y direction. Accordingly, the XYZ rectangular coordinate system illustrated in Fig. 3 to Fig. 6 does not coincide with that of the active gas generation apparatus 5 illustrated in Fig. 1 and Fig. 2.

As illustrated in Fig. 3, the high voltage apply electrode part 1 includes an electrode dielectric film 10 and a metal electrode 11 as main constituent elements. The electrode dielectric film 10 serves as a first electrode dielectric film constituting the high voltage electrode structure 13, and the metal electrode 11 serves as a first electrode conductive film constituting the high voltage electrode structure 13. The metal electrode 11 as the electrode conductive film is provided on the electrode dielectric film 10. The metal electrode 11 is formed on the electrode dielectric film 10 by sputtering, vapor deposition, or print burning.

The metal electrode 11 is made up of a body region 11m and a protrusion region 11t, and the body region 11m includes a rectangular planar region in a plan view in the XY plane surface. The X direction is a longitudinal direction, and the Y direction is a short-side direction in a planar region in each of the electrode dielectric film 10 and the body region 11m. The protrusion region 11t extends from a center portion of the body region 11m in a +Y direction to reach a longitudinal side of the electrode dielectric film 10. The electrode dielectric film 10 includes the body region 11m in the XY plane, and has a larger area than the body region 11m.

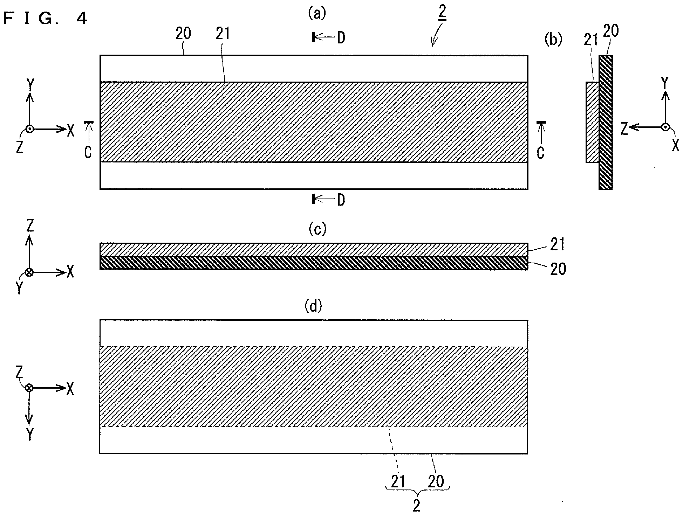

Fig. 4 is an explanation diagram illustrating a structure of the ground potential electrode part 2 as a constituent element of the ground electrode structure 14. Fig. 4(a) is a top view, Fig. 4(b) is a C-C cross-sectional view of Fig. 4(a), Fig. 4(c) is a D-D cross-sectional view of Fig. 4(a), and Fig. 4(d) is a bottom view. An XYZ rectangular coordinate system is illustrated in each of Fig. 4(a) to Fig. 4(d).

As illustrated in Fig. 4, the ground potential electrode part 2 includes an electrode dielectric film 20 and a metal electrode 21 as main constituent elements. The electrode dielectric film 20 serves as a G21^{th} electrode dielectric film constituting the ground electrode structure 14, and the metal electrode 21 serves as a second electrode conductive film constituting the ground electrode structure 14. The metal electrode 21 as the electrode conductive film is provided on the electrode dielectric film 20. The metal electrode 21 is formed on the electrode dielectric film 20 by sputtering, vapor deposition, or print burning.

The metal electrode 21 includes a rectangular planar region in a plan view in the XY plane surface. The X direction is a longitudinal direction, and the Y direction is a short-side direction in a planar region in each of the electrode dielectric film 20 and the metal electrode 21. A length of a long side of each of the electrode dielectric film 10 and the metal electrode 21 is set to be the same as each other, and the electrode dielectric film 20 includes the metal electrode 21 in the Y direction, and has a short side longer than the metal electrode 21.

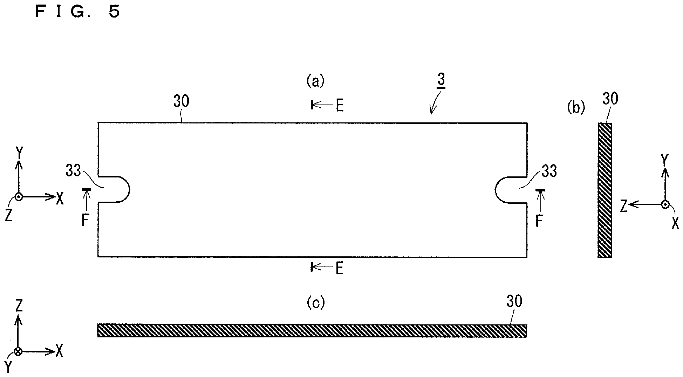

Fig. 5 is an explanation diagram illustrating a structure of the single electrode dielectric film 3. Fig. 5(a) is a top view, Fig. 5(b) is an E-E cross-sectional view of Fig. 5(a), and Fig. 5(c) is an F-F cross-sectional view of Fig. 5(a). An XYZ rectangular coordinate system is illustrated in each of Fig. 5(a) to Fig. 5(c).

As illustrated in Fig. 5, the single electrode dielectric film 3 is made up of only an electrode dielectric film 30, and the electrode dielectric film 30 (the single electrode dielectric film 3) has a rectangular planar region in a plan view in the XY plane surface. The X direction is a longitudinal direction, and the Y direction is a short-side direction in a planar region of the electrode dielectric film 30. A notch part 33 is provided in a center portion of each of both short sides of the electrode dielectric film 30.

The planar region of the electrode dielectric film 30 has substantially the same range as that of each of the electrode dielectric film 10 and the electrode dielectric film 20. Generally, the planar region of the electrode dielectric film 30 is preferably set to have the same area as that of the planar region of each of the electrode dielectric films 10 and 20.

The single electrode dielectric film 3 is used in first to third aspects described hereinafter. The first aspect is an aspect used as an auxiliary constituent element of the high voltage electrode structure 13. The second aspect is an aspect used as an auxiliary constituent element of the ground electrode structure 14. The third aspect is an aspect in which only the single electrode dielectric film 3 is independently used.

When the single electrode dielectric film 3 is used in the first and second aspects, it is referred to as "the electrode dielectric film 30", and when it is used in the third aspect, it is referred to as "the single electrode dielectric film 3" for convenience of description.

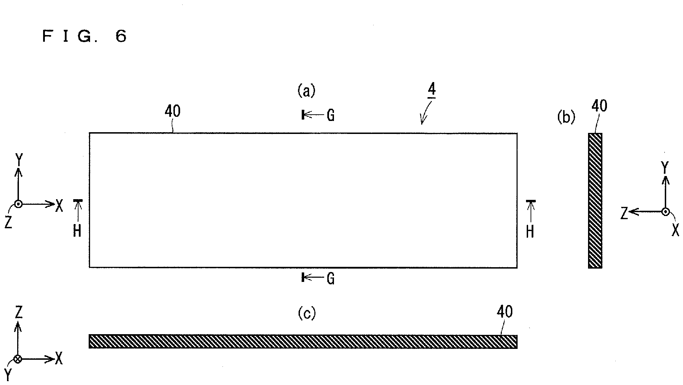

Fig. 6 is an explanation diagram illustrating a structure of the single electrode dielectric film 4. Fig. 6(a) is a top view, Fig. 6(b) is a G-G cross-sectional view of Fig. 6(a), and Fig. 6(c) is an H-H cross-sectional view of Fig. 6(a). An XYZ rectangular coordinate system is illustrated in each of Fig. 6(a) to Fig. 6(c).

As illustrated in Fig. 6, the single electrode dielectric film 4 is made up of only an electrode dielectric film 40, and the electrode dielectric film 40 (the single electrode dielectric film 4) has a rectangular planar region in a plan view in the XY plane surface. The X direction is a longitudinal direction, and the Y direction is a short-side direction in a planar region of the electrode dielectric film 40.

The planar region of the electrode dielectric film 40 has substantially the same area as that of the electrode dielectric film 10. The planar region of the electrode dielectric film 40 is preferably set to have the same area as that of the planar region of the electrode dielectric film 10.

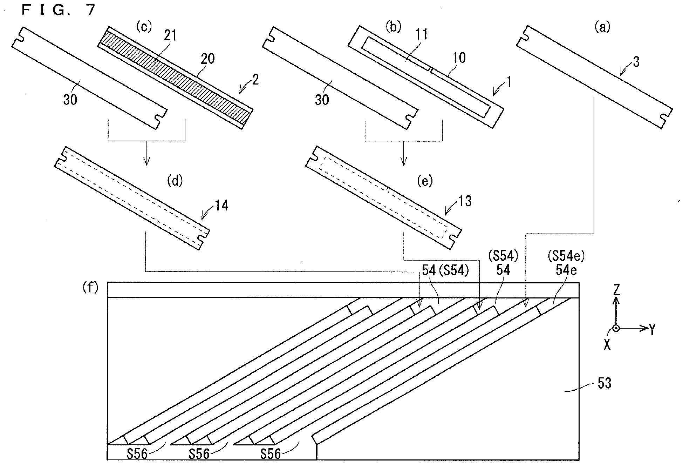

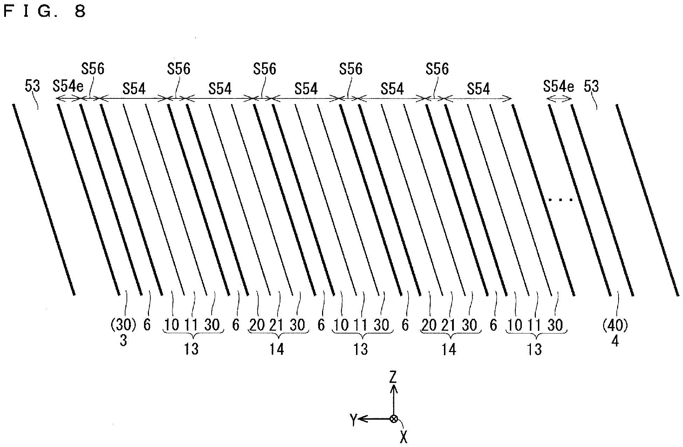

Fig. 7 and Fig. 8 are explanation diagrams each illustrating a state of holding the high voltage electrode structure 13 and a ground electrode structure 140 (14, 3, 4) in the plurality of grooves 54.

As illustrated in Fig. 7 and Fig. 8, the plurality of grooves 54 are provided along the Y direction as the predetermined formation direction in the generator base flange 53 as the discharge space structure. As illustrated in Fig. 8, the plurality of grooves 54 are provided separately from each other, and each of the plurality of grooves 54 includes the holding space S54.

As illustrated in Fig. 7(b) and Fig. 7(e), the high voltage electrode structure 13 includes a first complex structure made up of the electrode dielectric film 10, the metal electrode 11, and the electrode dielectric film 30. The electrode dielectric film 10 serves as the first electrode dielectric film, the metal electrode 11 serves as the first electrode conductive film, and the electrode dielectric film 30 serves as the first auxiliary dielectric film.

The electrode dielectric film 30 serving as the first auxiliary dielectric film is used in the first aspect described above in the high voltage apply electrode part 1. The planar region of each of the electrode dielectric film 10 and the metal electrode 11 and the planar region of the electrode dielectric film 30 serve as a first planar region in the high voltage electrode structure 13.

The electrode dielectric film 10, the metal electrode 11, and the electrode dielectric film 30 are stacked in this order in the first complex structure described above, and alternating-current voltage is applied to the metal electrode 11 from the high frequency power source 100 via the electrode connection line L1 (refer to Fig. 1 and Fig. 2). As illustrated in Fig. 3, the metal electrode 11 includes the protrusion region 11t, thus the high voltage electrode structure 13 can be held in the holding space S54 in the groove 54 so that the protrusion region 11t is located on an upper side (+Z direction in Fig. 1, Fig. 2, and Fig. 7). Accordingly, the electrode connection line L1 is connected to the protrusion region 11t of the metal electrode 11, thus the alternating-current voltage can be applied from the high frequency power source 100 to the metal electrode 11 relatively easily.

As illustrated in Fig. 7(c) and Fig. 7(d), the ground electrode structure 14 includes a second complex structure made up of the electrode dielectric film 20, the metal electrode 21, and the electrode dielectric film 30. The electrode dielectric film 20 serves as the second electrode dielectric film, the metal electrode 21 serves as the second electrode conductive film, and the electrode dielectric film 30 serves as the second auxiliary dielectric film.

The electrode dielectric film 30 serving as the second auxiliary dielectric film is used in the second aspect described above in the ground potential electrode part 2. The planar region of each of the electrode dielectric film 20 and the metal electrode 21 and the planar region of the electrode dielectric film 30 serve as a second planar region in the ground electrode structure 14.

The electrode dielectric film 20, the metal electrode 21, and the electrode dielectric film 30 are stacked in this order in the second complex structure described above, and the metal electrode 21 is set to have ground potential via the generator base flange 53 to which the ground potential as reference potential is supplied. As illustrated in Fig. 5, the electrode conductive film 30 includes the pair of notch parts 33 in the center of both short sides, thus the ground electrode structure 14 can be set to have the ground potential by making an electrical connection means such as a metal pin attached to the generator base flange 53 directly have contact with the metal electrode 21 via the notch parts 33.

As illustrated in Fig. 7(a), the single electrode dielectric film 3 is singularly used as the third aspect. The single electrode dielectric film 3 used in the third aspect is made as a part of the ground electrode structure. Furthermore, the single electrode dielectric film 4 is made as a part of the ground electrode structure.

In this manner, the second number of ground electrode structures include the ground electrode structure 14, the single electrode dielectric film 3, and the single electrode dielectric film 4. The ground electrode structure 14, the single electrode dielectric film 3, and the single electrode dielectric film 4 are collectively referred to as "the ground electrode structure 140" in some cases for convenience of description.

The single electrode dielectric film 3 illustrated in Fig. 5 and Fig. 7(a), the high voltage electrode structure 13 illustrated in Fig. 7(b) and Fig. 7(e), the ground electrode structure 14 illustrated in Fig. 7(c) and Fig. 7(d), and the signal electrode dielectric film 4 illustrated in Fig. 6 are held in the holding space S54 in the plurality of grooves 54 provided to the generator base flange 53 illustrated in Fig. 7(f).

As illustrated in Fig. 7 and Fig. 8, the first number of high voltage electrode structures 13 and the first number of grooves 54 in the plurality of grooves 54 correspond to each other, and each of the first number of high voltage electrode structures 13 is held in the holding space S54 in the corresponding groove 54 in the first number of grooves 54.

In the similar manner, the second number of ground electrode structures 140 and the second number of grooves 54 in the plurality of grooves 54 correspond to each other, and each of the second number of ground electrode structures 140 is held in the holding space S54 in the corresponding groove 54 in the second number of grooves 54.

The first number of high voltage electrode structures 13 and the second number of ground electrode structures 140 are alternately disposed along the Y direction, and the first planar region of each of the first number of high voltage electrode structures 13 and the second planar region of each of the second number of ground electrode structures 140 face each other with the separation space S56 therebetween.

The second number of grooves 54 include a pair of outermost grooves 54e located on an outermost side of the plurality of grooves 54 in the Y direction. Herein, the holding space S54 in each of the pair of outermost grooves 54e is referred to as an outermost holding space S54e.

The single electrode dielectric film 3 is held in the outermost holding space S54e in the outermost groove 54e on the side of the +Y direction, and the single electrode dielectric film 4 is held in the outermost holding space S54e in the outermost groove 54e on a side of a -Y direction. A formation width of the outermost holding space S54e is set to be substantially the same as a film thickness of the single electrode dielectric film 3 (the electrode dielectric film 30) or a film thickness of the single electrode dielectric film 4 (the electrode dielectric film 40). The film thickness of each of the single electrode dielectric film 3 and the single electrode dielectric film 4 is set to be the same as each other. The single electrode dielectric film 3 and the single electrode dielectric film 4 are used differently between the pair of outermost grooves 54e, thus suppression of disruption in assembling the active gas generation apparatus 5 can be expected.

A formation width of the holding space S54 except for the pair of outermost grooves 54e in the plurality of grooves 54 is set to be substantially the same as a film thickness of the high voltage electrode structure 13 or a film thickness of the ground electrode structure 14. The film thickness of the high voltage electrode structure 13 is equal to a sum of a film thickness of each of the electrode dielectric film 10, the metal electrode 11, and the electrode dielectric film 30. The film thickness of the ground electrode structure 14 is equal to a sum of a film thickness of each of the electrode dielectric film 20, the metal electrode 21, and the electrode dielectric film 30. A film thickness of each of the high voltage electrode structure 13 and the ground electrode structure 14 is generally set to be substantially the same as each other.

The planar region of the single electrode dielectric film 3 serving as the second planar region of the ground electrode structure 140 has a contact relationship with the generator base flange 53. Herein, a region having a contact relationship with the planar region of the single electrode dielectric film 3 is referred to as a first flange contact region in the generator base flange 53. This first flange contact region functions as the electrode conductive film corresponding to the single electrode dielectric film 3.

In the similar manner, the planar region of the single electrode dielectric film 4 serving as the second planar region of the ground electrode structure 140 has a contact relationship with the generator base flange 53. Herein, a region having a contact relationship with the planar region of the single electrode dielectric film 4 is referred to as a second flange contact region in the generator base flange 53. This second flange contact region functions as the electrode conductive film corresponding to the single electrode dielectric film 4.

In each separation space S56, a space sandwiched between the metal electrode 11 and the metal electrode 21 serves as the discharge space 6. That is to say, the discharge space 6 includes a region where the planar region of the metal electrode 11 and the planar region of the metal electrode 21 face each other in the separation space S56.

Accordingly, the separation space S56 includes the discharge space 6. However, a space where the metal electrode 11 and the first flange contact region described above face each other serves as the discharge space 6 in the outermost separation space S56 on a side of the +Y direction. In the similar manner, a space where the metal electrode 11 and the second flange contact region described above face each other serves as the discharge space 6 in the outermost separation space S56 on a side of the -Y direction.

In a basic aspect of the active gas generation apparatus 5, the first number of high voltage electrode structures 13 or the second number of ground electrode structures 140 are held in all of the holding spaces S54 in the plurality of grooves 54 provided to the generator base flange 53.

Herein, a combination of the first number of grooves 54 and the second number of grooves 54 are defined as a third number of discharge space formation grooves 54. In the basic aspect, a total number of the plurality of grooves 54 is the same as the third number.

Considered is a specific example that the first number is "13" and the second number is "14", for example. In the basic aspect, the third number is "27" and the total number of the plurality of grooves 54 is "27".

In the basic aspect, the single electrode dielectric film 3 and the single electrode dielectric film 4 are inserted into the outermost holding space S54e of the pair of outermost grooves 54e. As described above, each of the first and second flange contact regions in the generator base flange 53 functions as the electrode dielectric film.

The thirteen high voltage electrode structures 13 are held in the holding spaces S54 in the thirteen grooves 54. In the meanwhile, the twelve high voltage electrode structures 13 are held in the holding spaces S54 in the twelve grooves 54. At this time, the high voltage electrode structure 13 and the ground electrode structure 140 (the high voltage electrode structure 13, the single electrode dielectric film 3, or the single electrode dielectric film 4) are alternately disposed along the Y direction.

Accordingly, the high voltage electrode structure 13 is surely held in the holding space S54 in the groove 54 (referred to as "groove 54x") adjacent to the outermost groove 54e, and the ground electrode structure 14 is surely held in the holding space S54 in the groove 54 adjacent to the groove 54x on a side opposite to the outermost groove 54e. Subsequently, the high voltage electrode structure 13 and the ground electrode structure 140 are alternately disposed along the Y direction.

The high voltage electrode structure 13 and the ground electrode structure 140 adjacent to each other and the discharge space 6 between the high voltage electrode structure 13 and the ground electrode structure 140 adjacent to each other can constitute one unit of discharge cell. Accordingly, when the specific example described above is applied to the basic aspect, the twenty-six discharge cells (discharge space 6) in total are made in the generator base flange 53.

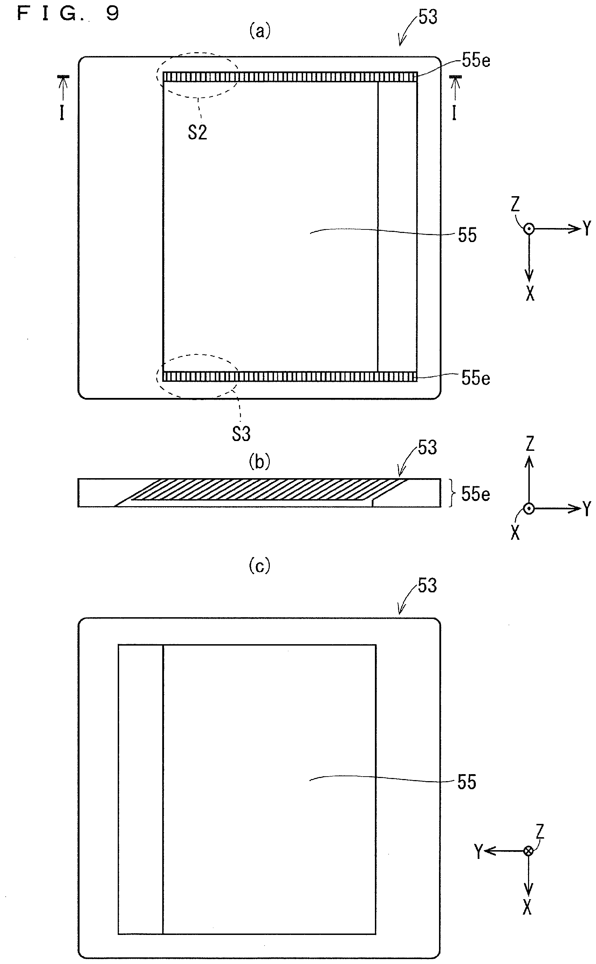

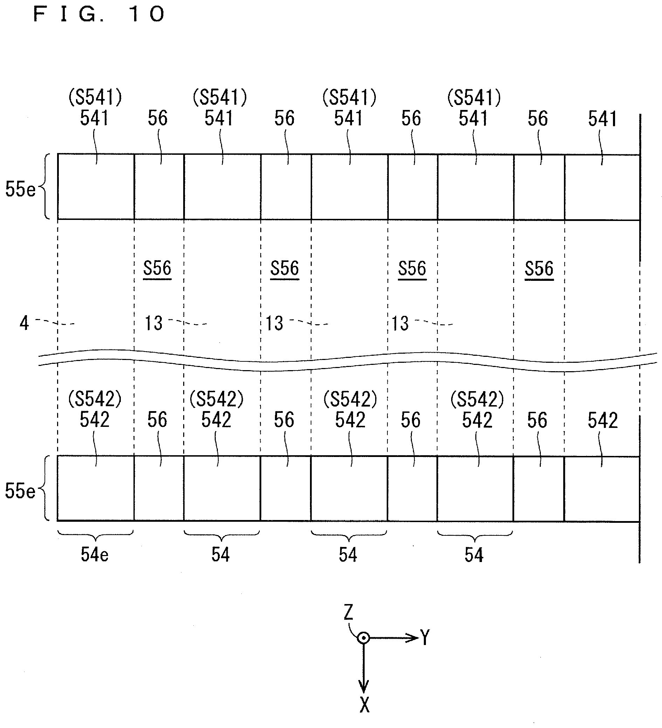

Fig. 9 is an explanation diagram illustrating a whole structure of the generator base flange 53. Fig. 9(a) is a top view, Fig. 9(b) is an I-I cross-sectional view of Fig. 9(a), and Fig. 9(c) is a bottom view. Fig. 10 is an explanation diagram illustrating structures of focus regions S2 and S3 in Fig. 9.

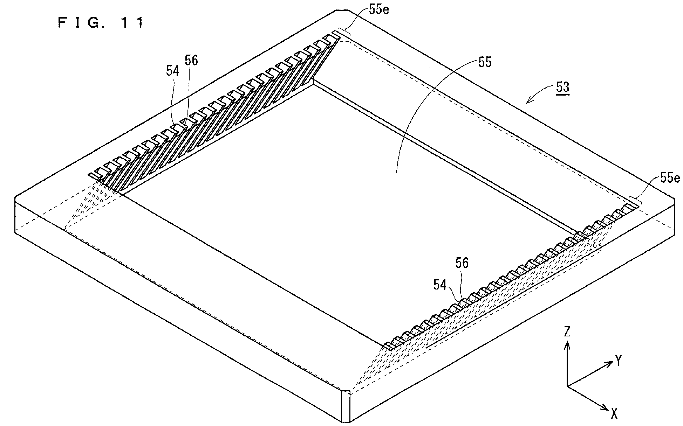

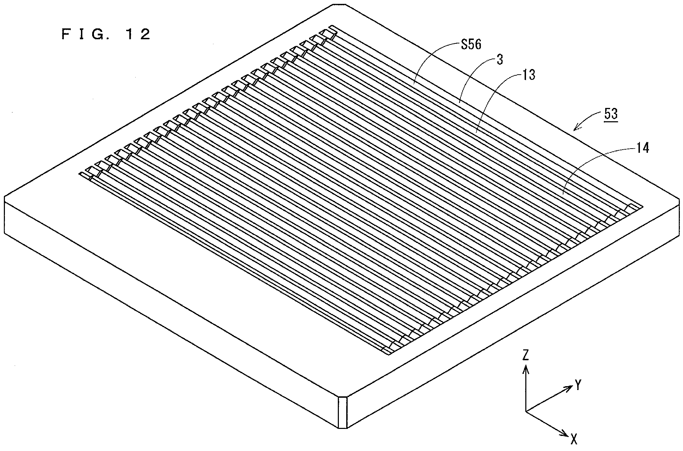

Fig. 11 and Fig. 12 are perspective views each illustrating a whole configuration of the generator base flange 53. Fig. 11 illustrates an initial state before the first number of high voltage electrode structures 13 and the second number of ground electrode structures 140 are held, and Fig. 12 illustrates a completion state after the first number of high voltage electrode structures 13 and the second number of ground electrode structures 140 are held. An XYZ rectangular coordinate system is illustrated in Fig. 9 to Fig. 12.

As illustrated in Fig. 9 and Fig. 11, the generator base flange 53 as the discharge space structure includes an opening region 55 passing through an inner side of the generator base flange 53. As illustrated in Fig. 9 and Fig. 10, the opening region 55 includes a pair of opening edge portions 55e facing each other in the X direction as a facing direction perpendicularly intersecting with the Y direction as the predetermined formation direction.

As illustrated in Fig. 10, each of the plurality of grooves 54 is made up of a pair of partial grooves 541 and 542. That is to say, each of the plurality of grooves 54 includes a pair of partial grooves 541 and 542 provided to the pair of opening edge portions 55e.

The plurality of partial grooves 541 are provided to the opening edge portion 55e of the opening region 55 on the side of the -Y direction, and the plurality of partial grooves 542 are provided to the opening edge portion 55e of the opening region 55 on the side of the +X direction. Each of the plurality of partial grooves 541 includes a partial holding space S541 directed to the -Z direction and extending to have a predetermined inclination with respect to the vertical direction (Z direction). In the similar manner, each of the plurality of partial grooves 542 includes a partial holding space S542 directed to the -Z direction and extending to have a predetermined inclination. In this manner, the holding space S54 in the groove 54 includes the partial holding space S541 in the partial groove 541 and the partial holding space S542 in the partial groove 542.

The predetermined inclination of each of the pair of partial holding spaces S541 and S542 is a space extending in a space formation direction coinciding with the gas flow direction FG.

The partial holding space S541 is a space surrounded by a bottom portion not shown in the drawings but provided on a lower side of the opening edge portion 55e on the side of the -X direction, a pair of groove sidewall parts 56 sandwiching the partial holding space S541, and an exposed surface of the opening edge portion 55e on the side of the -X direction corresponding to the partial holding space S541.

In the similar manner, the partial holding space S542 is a space surrounded by a bottom portion not shown in the drawings but provided on the lower side of the opening edge portion 55e on the side of the +X direction, a pair of groove sidewall parts 56 sandwiching the partial holding space S542, and an exposed surface of the opening edge portion 55e on the side of the +X direction corresponding to the partial holding space S542.

As illustrated in Fig. 10, a short side region of the single electrode dielectric film 4 on the side of the -X direction is held in the partial holding space S541 in the outermost groove 54e on the side of the -Y direction, and a short side region thereof on the side of the +X direction is held in the partial holding space S542. As a result, the single electrode dielectric film 4 is held in the holding space S54 in the outermost groove 54e.

In the groove 54 (referred to as "the groove 54α") adjacent to the outermost groove 54e, the short side region of the high voltage electrode structure 13 on the side of the -X direction is held in the partial holding space S541, and the short side region thereof on the side of the +X direction is held in the partial holding space S542. As a result, the high voltage electrode structure 13 is held in the holding space S54 in the groove 54α.

In the groove 54 (referred to as "the groove 54β") adjacent to the groove 54α on the side of the +Y direction, the short side region of the ground electrode structure 14 on the side of the -X direction is held in the partial holding space S541, and the short side region thereof on the side of the +X direction is held in the partial holding space S542. As a result, the ground electrode structure 14 is held in the holding space S54 in the groove 54β.

Subsequently, the high voltage electrode structure 13 and the ground electrode structure 14 are alternately held in the holding space S54 in the groove 54, and the single electrode dielectric film 3 is held in the holding space S54 in the outermost groove 54e on the side of the +Y direction.

In this manner, an inner space in each of the plurality of grooves 54 serves as the holding space S54 (S541 and S542), and both end portions of the first planar region of the first number of high voltage electrode structures 13 are held in the pair of partial holding spaces S541 and S542. The pair of short side regions of each of the electrode dielectric film 10 and the electrode dielectric film 30 fall under both end portion of the first planar region of the high voltage electrode structure 13. Accordingly, a large part of the first planar region of the high voltage electrode structure 13 except for the pair of short side regions is exposed in the opening region 55.

In the similar manner, both end portions of the second planar region of the second number of ground electrode structures 140 are held in the pair of partial holding spaces S541 and S542. The pair of short side regions of each of the electrode dielectric film 20, the metal electrode 21, and the electrode dielectric film 30 fall under both end portion of the second planar region in a case of the ground electrode structure 14, for example. The pair of short side regions of the single electrode dielectric film 3 (30) falls under both end portions of the second planar region in a case of the single electrode dielectric film 3, and the pair of short side regions of the single electrode dielectric film 4 (40) falls under both end portions of the second planar region in a case of the single electrode dielectric film 4, for example.

Accordingly, a large part of both surfaces of the second planar region of the ground electrode structure 14 except for both end portions on the side of the short side is exposed in the opening region 55. However, in the single electrode dielectric film 3, a large part of the second planar region on a side opposite to the first flange contact region is exposed in the opening region 55, and in the single electrode dielectric film 4, a large part of the second planar region on a side opposite to the second flange contact region is exposed in the opening region 55.

As described above, the pair of partial holding spaces S541 and S542 are directed to the -Z direction, and have the significant predetermined inclination, thus the separation space S56 provided between the high voltage electrode structure 13 and the ground electrode structure 140 adjacent to each other in the Y direction is also directed to the -Z direction, and has the predetermined inclination in the completion state illustrated in Fig. 10 and Fig. 12 in the opening region 55 in the chamber 52.

Accordingly, in the discharge space 6 formed in the separation space S56, the gas flow direction FG directed to the gas ejection port 6b from the gas supply port 6a is also directed to the -Z direction and has the predetermined inclination.

As described above, twelve ground electrode structures 14 are held in the holding spaces S54 in twelve grooves 54 in the specific example described above in the basic aspect. At this time, the metal electrode 21 of the ground electrode structure 14 has contact with the groove sidewall part 56 via an electrical connection means such as a metal pin. That is to say, in the second complex structure described above of the ground electrode structure 14, the metal electrode 21 as the second electrode conductive film has an electrical connection relationship with the generator base flange 53 as the discharge space structure.

In the active gas generation apparatus 5 having such a configuration, the alternating-current voltage is applied to the metal electrode 11 of the first number of high voltage electrode structures 13 from the high frequency power source 100 via the electrode connection line L1. In the meanwhile, the metal electrode 21 of the ground electrode structure 14 has contact with the groove sidewall part 56 via a metal pin, thereby being set to have ground potential as a reference battery via the generator base flange 53. The ground potential is supplied to the generator base flange 53, thus the first and second flange contact regions described above are set to have ground potential.

As a result, a dielectric barrier discharge is generated in the discharge space 6 in each of the plurality of discharge cells provided to the generator base flange 53.

Accordingly, the material gas G1 supplied into the material gas supply space 61 from the gas supply opening part 50 is activated when passing through the discharge space 6 to be the active gas G2. When the active gas G2 is supplied to the active gas output space 62 in the chamber 52 along the gas flow direction FG to be blown onto the wafer 7 disposed on the substrate mounting surface 57S of the wafer support table 57. As a result, manufacturing processing by the active gas G2 on the surface of the wafer 7 is performed.

The active gas G2 is ejected along the gas flow direction FG from the gas ejection port 6b of the discharge space 6. The gas ejection port 6b has a slit-like shape, and the gas flow direction FG is set to be an oblique direction having a significant predetermined inclination with respect to the vertical direction (the +Z direction) with respect to the surface of the wafer 7 as the substrate.

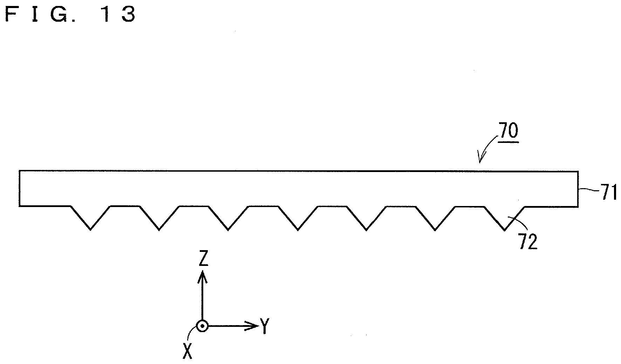

Fig. 13 is an explanation diagram schematically illustrating a structure of a press member 70. An XYZ rectangular coordinate system is illustrated in Fig. 13. As illustrated in Fig. 13, the press member 70 includes a member body 71 and a plurality of press protrusion regions 72 as main constituent elements.

The plurality of press protrusion regions 72 are provided on a lower side of the member body 71 along the Y direction to correspond to the plurality of grooves 54 on a one-on-one basis. Each of the plurality of press protrusion regions 72 includes a tip end portion having an acute angle on a lower side. An interval of formation of the plurality of press protrusion regions 72 is set to be the same as that of the plurality of grooves 54 in the generator base flange 53.

As illustrated in Fig. 10 and Fig. 12, the press member 70 is used after the completion state where the first number of high voltage electrode structures 13 and the second number of ground electrode structures 14 are held by the plurality of grooves 54 of the generator base flange 53.

For example, press force is applied to the press member 70 in the -Z direction while the tip end portions of the plurality of press protrusion regions 72 have direct contact with the high voltage electrode structure 13 or the ground electrode structure 140, thus the first number of high voltage electrode structures 13 and the second number of ground electrode structures 140 disposed in the holding spaces S54 in the plurality of grooves 54 can be pressed by the plurality of press protrusion regions 72.

As a result, the active gas generation apparatus 5 according to the present embodiment can fix the first number of high voltage electrode structures 13 and the second number of ground electrode structures 140 in a state of stably holding them in the holding spaces S54 in the plurality of grooves 54.

### (Main effect)

In the active gas generation apparatus 5 according to the present embodiment, the high voltage electrode structure 13 and the ground electrode structure 140 adjacent to each other in the Y direction as the predetermined formation direction and the discharge space 6 between the high voltage electrode structure 12 and the ground electrode structure 140 adjacent to each other constitute one unit of discharge cell. Accordingly, when at least one of the first number and the second number is set to be equal to or larger than "2", the plurality of discharge cells can be provided to the generator base flange 53 as the discharge space structure.

The material gas G1 supplied from the material gas supply space 61 via the gas supply port 6a of the discharge space 6 is activated in the discharge space 6 in each of the plurality of discharge cells to generate the active gas G2. The active gas G2 is ejected from the gas ejection port 6b of the discharge space 6 toward the active gas output space 62.

In the active gas generation apparatus 5 of the present embodiment, a large part of a gas distribution path from the gas supply port 6a to the gas ejection port 6b can serve as the discharge space 6, and a structure being an obstacle needs not be provided to the gas distribution path. Thus, the active gas generation apparatus 5 according to the present embodiment can effectively suppress inactivation of the active gas G2 by reason that the active gas G2 flows smoothly in the discharge space 6.

That is to say, there is no shielding object for the active gas G2 flowing along the gas flow direction FG to reach the wafer 7 from the gas ejection port 6b via the discharge space 6, and the active gas G2 is not compressed. In this manner, the active gas generation apparatus 5 according to the present embodiment has a structure enabling a smooth flow of the active gas G2. Such a flow of the active gas G2 is achieved, thus excessive inactivation of the radical is suppressed in the active gas G2.

As a result, the active gas generation apparatus 5 according to the present embodiment can supply the high concentration active gas G2 from the gas ejection port 6b of each of the plurality of discharge cells to the active gas output space 62 in the subsequent stage.

In the active gas generation apparatus 5 according to the present embodiment, a gas supply hole and a gas ejection hole need not be provided to the high voltage electrode structure 13 and the ground electrode structure 140, thus the discharge space 6 in each of the plurality of discharge cells can be secured with sufficiently large volume.

In addition, in the active gas generation apparatus 5 according to the present embodiment, the plurality of discharge cells can be made up with a relatively simple structure of holding both end portions of the first number of high voltage electrode structures 13 on the side of the short side in the holding spaces S54 in the first number of grooves 54 and holding both end portions of the second number of ground electrode structures 140 on the side of the short side in the holding spaces S54 in the second number of grooves 54, thus reduction of the manufacturing cost can be achieved.

This point is described in detail hereinafter. The high voltage apply electrode part 1 and the electrode dielectric film 30 merely hold the structure in the holding space S54 in the groove 54 in the high voltage electrode structure 13. In the similar manner, the ground potential electrode part 2 and the electrode dielectric film 30 merely hold the structure in the holding space S54 in the groove 54 in the ground electrode structure 14.

That is to say, the high voltage electrode structure 13 does not need an excessive operation process and component such as an attachment or a grasping mechanism between the high voltage apply electrode part 1 and the electrode dielectric film 30. In the similar manner, the ground electrode structure 14 does not need an excessive operation process and component such as an attachment or a grasping mechanism between the ground potential electrode part 2 and the electrode dielectric film 30.

In this manner, the active gas generation apparatus 5 according to the present embodiment is provided with the plurality of discharge cells with the extremely simple structure.

The gas flow direction FG directed from the gas supply port 6a of the discharge space 6 toward the gas ejection port 6b is set to be the oblique direction having the significant predetermined inclination (for example, 30° to 60°) not "0" with respect to the vertical direction (Z direction) with respect to the substrate mounting surface 57S. Thus, the active gas G2 ejected from the slit-like gas ejection port 6b has contact with the surface of the wafer 7 disposed on the substrate mounting surface 57S in the significant inclination, and subsequently, the active gas G2 smoothly proceeds along the surface of the wafer 7.

Thus, inactivation of the active gas G2 caused by the collision of the active gas G2 on the surface of the wafer 7 can be suppressed without reducing the flow speed of the active gas G2 ejected from the gas ejection port 6b.

As a result, the active gas generation apparatus 5 according to the present embodiment can supply the high concentration active gas G2 to a relatively large region in the surface of the wafer 7 at a desired flow speed.

In this manner, the first number of high voltage electrode structures 13 and the second number of ground electrode structures 140 are disposed in the oblique direction with respect to the substrate mounting surface 57S on which the wafer 7 is disposed, thus the gas flow direction FG of the active gas G2 containing radical has contact with the surface of the wafer 7 in the inclination. Drastic collision of the active gas G2 along the vertical direction is prevented. Thus, excessive inactivation of the radical is prevented in the active gas G2, and reduction of the gas flow speed of the active gas G2 is prevented. Accordingly, the manufacturing process can be performed in a large range on the surface of the wafer 7.

In the active gas generation apparatus 5 according to the present embodiment, the holding space S54 included in each of the plurality of grooves 54 includes the pair of partial holding spaces S541 and S542 extending in the space formation direction coinciding with the gas flow direction FG.

Thus, the gas flow direction FG in the discharge space 6 of the plurality of discharge cells provided to the generator base flange 53 of the active gas generation apparatus 5 according to the present embodiment can be set in the oblique direction relatively easily.

In the active gas generation apparatus 5 according to the present embodiment, the discharge space 6 is provided between the first complex structure of the high voltage electrode structure 13 and the second complex structure of the ground electrode structure 14.

Accordingly, the active gas generation apparatus 5 according to the present embodiment can generate the active gas G2 by activating the material gas G1 by the dielectric barrier discharge generated in the discharge space 6.

Pressure in the discharge space 6 needs to be equal to or larger than 75 Torr (10 kPa) in accordance with a feature of the dielectric barrier discharge. The active gas generation apparatus 5 according to the present embodiment does not include a throttle mechanism such as an orifice between the discharge space 6 and the active gas output space 62, thus the pressure in the active gas output space 62 can be set to be equal to or larger than 75 Torr in the manner similar to the discharge space 6. It is possible to set the pressure in the discharge space 6 to be equal to or larger than 75 Torr by an existing technology.

Accordingly, the active gas generation apparatus 5 according to the present embodiment can apply high pressure deposition processing to the wafer 7 and the active gas output space 62 relatively easily.

The metal electrode 21 of the ground electrode structure 14 has the electrical connection relationship with the groove sidewall part 56 of the generator base flange 53. That is to say, in the second complex structure described above of the ground electrode structure 14, the metal electrode 21 as the second electrode conductive film is electrically connected to the generator base flange 53 as the discharge space structure via the electrical connection means such as the metal pin.

Thus, the active gas generation apparatus 5 according to the present embodiment can set the ground electrode structure 14 to have the ground potential relatively easily using the electrical connection means such as the metal pin.

The single electrode dielectric film 3 or the single electrode dielectric film 4 disposed in the holding space S54 in the outermost groove 54e use the first and second flange contact regions in the generator base flange 53 to which the ground potential is applied as the electrode conductive film. Thus, the high voltage electrode structure 13 and the single electrode dielectric film 3 (4) adjacent to each other in the Y direction and the discharge space 6 located between the high voltage electrode structure 13 and the single electrode dielectric film 3 (4) adjacent to each other can constitute the outermost discharge cell.

Accordingly, the ground electrode structure 140 held in the outermost holding space S54e in the outermost groove 54e can be made up only the single electrode dielectric film 3 (4), thus the configuration of the apparatus can be simplified.

### (Selective usage of plurality of grooves 54 (modification aspect))

In the basic aspect described above, the first number of high voltage electrode structures 13 and the second number of ground electrode structures 140 are held using all of the plurality of grooves 54. Considered is a modification aspect of holding the first number of high voltage electrode structures 13 and the second number of ground electrode structures 140 using only some of the plurality of grooves 54 in addition to the basic aspect. The modification aspect is described in detail hereinafter.

Herein, a combination of the first number of grooves 54 and the second number of grooves 54 are defined as a third number of practical usage grooves 54u. In the modification aspect, some of the plurality of grooves 54 serve as the third number of practical usage grooves 54u.

For example, in a case where a total number of the plurality of grooves 54 is "27", when the first number is "10" and the second number is "11", the third number is "21". In this case, six grooves 54 serve as a fourth number ("6") of non-use grooves 54z into which the high voltage electrode structure 13 and the ground electrode structure 140 are not inserted.

In this manner, the plurality of grooves 54 are classified into the third number of practical usage grooves 54u and the fourth number of non-use grooves 54z in the modification aspect. In the basic aspect, all of the plurality of grooves 54 serve as the third number of practical usage grooves 54u as described above.

In the modification aspect, some of the plurality of grooves 54 are selectively used as the third number of practical usage grooves 54u, thus a supply region where the active gas G2 is supplied in the active gas output space 62 can be set to have a desired area.

For example, when a processing region where the wafer 7 is processed is relatively small, the supply region of the active gas G2 can be set to be appropriate for the processing region by setting the third number to be smaller than a total number of the plurality of grooves 54.

In this manner, the third number of practical usage grooves 54u can be increased and reduced by the basic aspect and the modification aspect. The third number can be increased and reduced in accordance with the state, however, a magnitude of the discharge space 6 of each discharge cell is always constant regardless of the third number. Accordingly, a radical concentration of the active gas G2 ejected from the gas ejection port 6b is constant without depending on the third number, thus a deposition range in the wafer 7, for example, can be changed without changing a time of processing the wafer 7.

In the modification aspect, it is preferable to fill a non-use separation space S56z which is adjacent to the holding space S54 of the non-use groove 54z and the non-use groove 54z and is not provided with the discharge space 6. The non-use separation space S56z indicates a virtual separation space including the discharge space 6 in a case where the high voltage electrode structure 13 or the ground electrode structure 140 is held in the holding space S54 in the non-use groove 54z.

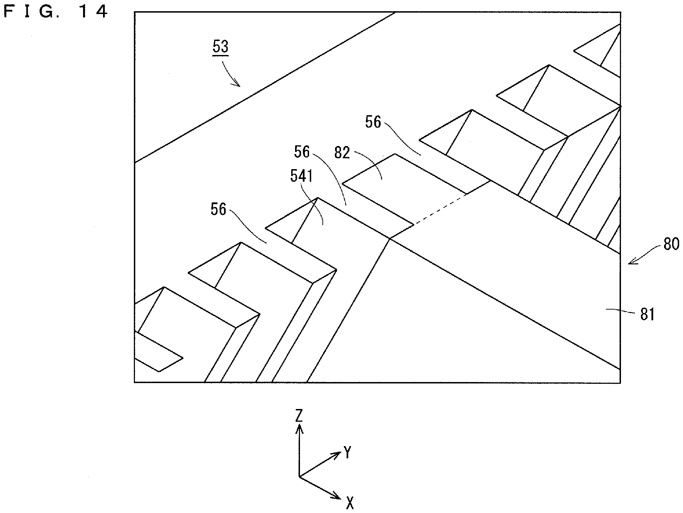

Fig. 14 is an explanation diagram schematically illustrating a usage example of a blank component 80 for the non-use groove 54z. As illustrated in Fig. 14, the blank component 80 includes a component body 81 and a pair of groove protrusion parts 82 as main constituent elements.

The groove protrusion part 82 on the side of the -X direction in the pair of groove protrusion parts 82 has the same formation width as the partial holding space S541 of the non-use groove 54z, and has the same formation length as the partial holding space S541 (the groove sidewall part 56). In the similar manner, the groove protrusion part 82 on the side of the +X direction in the pair of groove protrusion parts 82 has the same formation width as the partial holding space S542 of the non-use groove 54z, and has the same formation length as the partial holding space S542 (the groove sidewall part 56).

In the meanwhile, the component body 81 has the same formation width as a total formation width of the partial holding space S541 and the non-use separation space S56z, and has the same formation length as a distance between the groove sidewall parts 56 and 56 facing in the X direction.

The blank component 80 is disposed in the opening region 55 in the generator base flange 53 so that the pair of groove protrusion parts 82 are located in the partial holding spaces S541 and S542, thus the holding space S54 (the partial holding spaces S541 and S542) in the non-use groove 54z and the non-use separation space S56z can be filled. Thus, the material gas G1, for example, does not pass through the holding space S54 in the non-use groove 54z and the non-use separation space S56z at a time of using the active gas generation apparatus 5.

In this manner, the modification aspect of the active gas generation apparatus 5 further includes the blank component 80 disposed to fill the holding spaces S54 in the fourth number of non-use grooves 54z and the fourth number of non-use separation spaces S56z.

On unit of blank component 80 is provided to correspond to one non-use groove 54z and non-use separation space S56z, thus the fourth number of blank components 80 need to be disposed to correspond to the fourth number of non-use grooves 54z.

According to the modification aspect of the embodiment, the blank component 80 blocks the flow of gas in the holding space S54 in the non-use groove 54z and the non-use separation space S56z, thus even when the fourth number of non-use grooves 54z are provided, they do not have a negative influence on the feature of the active gas G2 including the concentration and flow speed thereof.

In this manner, even when the fourth number of non-use grooves 54z are set in some of the plurality of grooves 54, the range where the wafer 7 is processed can be easily changed by locating the fourth number of blank components 80 corresponding to the fourth number of non-use grooves 54z without the negative influence on the feature of the active gas G2.

The present disclosure is described in detail, however, the foregoing description is in all aspects illustrative, thus the present disclosure is not limited thereto. It is therefore understood that numerous modification examples not exemplified can be devised without departing from the scope of the present disclosure.

### EXPLANATION OF REFERENCE SIGNS

1 high voltage apply electrode part
2 ground potential electrode part
3, 4 single electrode dielectric film
5 active gas generation apparatus
7 wafer
10, 20, 30, 40 electrode dielectric film
11, 21 metal electrode
13 high voltage electrode structure
14, 140 ground electrode structure
51 generator cover
52 chamber
53 generator base flange
54 groove
54e outermost groove
56 groove sidewall part
57 wafer support table
61 material gas supply space
62 active gas output space
70 press member
80 blank component
100 high frequency power source
541, 542 partial groove
G1 material gas
G2 active gas
S54 holding space
S56 separation space
S541, S542 partial holding space

## Claims

1. An active gas generation apparatus, comprising:
a material gas supply space;
an active gas output space;
a first number of high voltage electrode structures each having a rectangular first planar region in a plan view;
a second number of ground electrode structures each having a rectangular second planar region in a plan view; and
a discharge space structure provided between the material gas supply space and the active gas output space, wherein
the discharge space structure includes a plurality of grooves provided along a predetermined formation direction,
the plurality of grooves are provided separately from each other, and each of the plurality of grooves includes a holding space,
the first number of high voltage electrode structures and a first number of grooves in the plurality of grooves correspond to each other, and the first number of high voltage electrode structures are held in the holding space in corresponding grooves in the first number of grooves, respectively,
the second number of ground electrode structures and a second number of grooves in the plurality of grooves correspond to each other, and the second number of ground electrode structures are held in the holding space in corresponding grooves in the second number of grooves, respectively,
the first number of high voltage electrode structures and the second number of ground electrode structures are alternately disposed along the predetermined formation direction, and the first planar region of each of the first number of high voltage electrode structures and the second planar region of each of the second number of ground electrode structures face each other with a separation space therebetween,
alternating-current voltage is applied to the first number of high voltage electrode structures, the second number of ground electrode structures are set to have reference potential, and the separation space includes a discharge space, and
an opening part of the discharge space on a side of the material gas supply space serves as a gas supply port, an opening part of the discharge space on a side of the active gas output space serves as a gas ejection port, and a direction from the gas supply port toward the gas ejection port is regulated as a gas flow direction.

2. The active gas generation apparatus according to claim 1, further comprising:
a substrate support table provided in the active gas output space and including a substrate mounting surface on which a substrate is disposed, wherein
the gas ejection port has a slit-like shape, and
the gas flow direction is set to be an oblique direction having a predetermined inclination with respect to a vertical direction with respect to the substrate mounting surface.

3. The active gas generation apparatus according to claim 2, wherein
the discharge space structure includes an opening region passing through an inner side of the discharge space structure, and the opening region includes a pair of opening edge portions facing each other in a facing direction intersecting with the predetermined formation direction,
each of the plurality of grooves includes a pair of partial grooves provided in the pair of opening edge portions,
the holding space is provided in each of the pair of partial grooves, and includes a pair of partial holding spaces extending in a space formation direction coinciding with the gas flow direction,
both end portions of the first planar region of each of the first number of high voltage electrode structures are held in the pair of partial holding spaces, and
both end portions of the second planar region of each of the second number of ground electrode structures are held in the pair of partial holding spaces.

4. The active gas generation apparatus according to any one of claims 1 to 3, wherein
the high voltage electrode structure includes a first complex structure made up of a first electrode dielectric film, a first electrode conductive film, and a first auxiliary dielectric film, the first electrode dielectric film, the first electrode conductive film, and the first auxiliary dielectric film are stacked in this order in the first complex structure, and the alternating-current voltage is applied to the first electrode conductive film, and
the ground electrode structure includes a second complex structure made up of a second electrode dielectric film, a second electrode conductive film, and a second auxiliary dielectric film, the second electrode dielectric film, the second electrode conductive film, and the second auxiliary dielectric film are stacked in this order in the second complex structure, and the second electrode conductive film is set to have the reference potential.

5. The active gas generation apparatus according to claim 4, wherein
the discharge space structure has conductivity, and the reference potential is provided to the discharge space structure, and
the second electrode conductive film is electrically connected to the discharge space structure in the second complex structure of the ground electrode structure.

6. The active gas generation apparatus according to claim 5, wherein
the ground electrode structure further includes a single electrode dielectric film having the second planar region,
the second number of grooves include an outermost groove located on an outermost side in the predetermined formation direction in the plurality of grooves, and
the single electrode dielectric film is held in the holding space in the outermost groove, and the second planar region has a contact relationship with the discharge space structure.

7. The active gas generation apparatus according to any one of claims 1 to 6, wherein
a combination of the first number of grooves and the second number of grooves is defined as a third number of discharge space formation grooves, and
some of the plurality of grooves serve as a third number of discharge space formation grooves.

8. The active gas generation apparatus according to claim 7, wherein
a groove in the plurality of grooves except for the third number of discharge space formation grooves is classified into a fourth number of non-use grooves, and
the active gas generation apparatus further includes a blank component disposed to fill the holding space in the fourth number of non-use grooves and the separation space adjacent to the fourth number of non-use grooves.
